# EUROPEAN PATENT APPLICATION

(11) **EP 0 637 189 A2**
(43) Date of publication of application: **01.02.1995**
(21) Application number: 94305552.5
(22) Date of filing: 27.07.1994
(51) Int. Cl.: H04R 5/04

(54) **Audio signal processing circuit**

(30) Priority: 27.07.1993 JP 184623/93
(71) Applicant: KABUSHIKI KAISHA TOSHIBA, Kawasaki-shi, Kanagawa-ken 210 (JP)
(72) Inventor: Muramatsu, Yasuhiro, c/o Intel. Property Division, Minato-ku, Tokyo (JP)
(74) Representative: O'Connell, David Christopher

(57) **Abstract**

An audio signal processing circuit includes an amplifier having a non-inverting input terminal, an inverting input terminal and an output terminal with an RC active filter connected across the output terminal and the inverting input terminal, means for supplying first and second audio signal to the inverting input terminal of the amplifier through a first input resistor (R1L), of which one end is connected to the first audio signal input terminal, and a second input resistor (R1R), of which one end is connected to the second audio signal input terminal, respectively, and a third resistor (R3) connected between the connection node of the first and the second input resistors and a reference potential source.

## Description

The present invention generally relates to an audio signal processing circuit, and more particularly to a low frequency audio signal intensifying circuit.

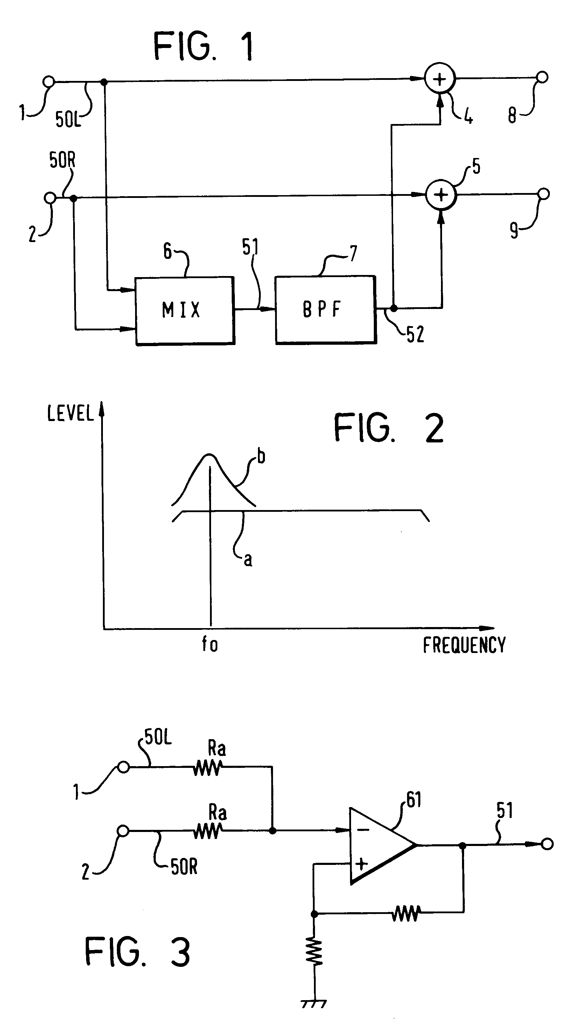

Previously, it has been found to be desirable to intensify low frequency sound signals in TV receivers, stereo sets and other such devices to enjoy a powerful sound. Figure 1 shows a conventional audio signal processing circuit for intensifying a prescribed low band audio signal. In the drawing, reference numeral 1 denotes an input terminal to which a left channel audio signal 50L is input. Reference numeral 2 denotes another input terminal to which a right channel audio signal 50R is input. These left and right channel audio signals 50L and 50R applied through the left and right channel input terminals 1 and 2 are then applied to adders 4 and 5, respectively, and also to an audio signal mixing circuit 6. This audio signal mixing circuit 6 mixes the left and right channel input audio signals 50L and 50R with each other to form a monaural audio signal 51 and leads this monaural audio signal to a band-pass filter 7. As this band-pass filter 7 admits only audio signals in the band around the resonance frequency (fo) of the left and the right loudspeakers (not shown) to pass through it, only a band component 52 out of the monaural signal 51 is output from the band-pass filter 7 and then led to the adders 4 and 5.

Therefore, the adder 4 adds the low frequency audio signal 52 output from the band-pass filter 7 to the left channel audio signal 50L and outputs the resulting left channel audio signal to a left channel output terminal 8. Further, the adder 5 adds the low frequency audio signal 52 also output from the bandpass filter 7 to the right channel audio signal 50R and then outputs the resulting right channel audio signal to a right channel output terminal 9. As a result, the left and right channel audio signals having the frequency characteristic curve b as shown in Figure 2 are obtained from the adders 4 and 5. The low frequency audio signal 52 output from the band-pass filter 7 has the frequency characteristic curve b with its band component around the loudspeaker's resonance frequency Fo being intensified in contrast to the frequency characteristic curve a of the input audio signals 50L and 50R, as shown in Figure 2.

Figure 3 shows the detail of the audio signal mixing circuit 6 shown in Figure 1. The left and the right channel audio input signals 50L and 50R are applied to the inverting (-) input terminal of an operational amplifier 61 through input resistors Ra and Rb, respectively. Thus the left and the right channel audio input signals 50L and 50R are mixed with each other to form a monaural audio signal 51 in the operational amplifier 61.

The conventional audio signal processing circuit as shown in Figure 1 has the advantage that a prescribed band audio component can be intensified easily using only the left and the right channel loudspeakers without providing a third loudspeaker for the low frequency audio signal. However, it has a drawback in that the audio signal mixing circuit 6 and the band-pass filter 7 are both needed. As a result, the previously known circuits are large in size and are expensive.

As described above, previously known audio signal processing circuits with a simple construction are capable of intensifying a prescribed low frequency audio signal by using only the left and the right channel loudspeakers. However, this previously known construction, in which the low frequency component of the monaural signal, obtained by mixing the left and the right channel audio signals, is filtered and then added to the left and right channel input audio signals, has the drawback that an audio signal mixing circuit for obtaining a monaural signal and a band-pass filter to extract the low frequency component are needed and the circuit is large in size and expensive.

The present invention seeks to provide an audio signal processing circuit which is able to overcome the drawbacks of the previously known audio signal processing circuit.

Therefore, the present invention seeks to provide an audio signal processing circuit which is able to intensify a prescribed low frequency band of the audio signal by using a circuit which has a simple construction and is inexpensive.

According to the present invention there is provided an audio signal processing circuit, comprising:
an amplifier having an input terminal and an output terminal with an RC filter connected between the output terminal and the input terminal;
a first input resistor for supplying a first audio signal to the input terminal of the amplifier;
a second input resistor for supplying a second audio signal to the input terminal of the amplifier; and
a third resistor connected between a connection node of the first and the second input resistors and a reference potential source.

The audio signal processing circuit also advantageously comprises:
means for supplying a left channel audio signal to the first input resistor;
means for supplying a right channel audio signal to the second input resistor;
first combining means for combining the output signal from the amplifier with the left channel audio signal to form an output left channel audio signal; and
second combining means for combining the output signal from the amplifier with the right channel audio signal to form an output right channel audio signal.

In the audio signal processing circuit according to the present invention, the band-pass filter, comprising an RC active filter containing an amplifier and an RC circuit, extracts a prescribed band signal component from the audio signal input from a single input terminal of the amplifier and outputs it through the output of the amplifier. The input resistors are commonly connected to the inverting input terminal of the amplifier through a coupling capacitor, while the grounding resistor is coupled between the connecting node of the first and the second input resistors and ground. As a result, as the ends of the input resistors are connected to each other, the left and the right channel audio signals that are input through the other ends of these input resistors are mixed with each other, resulting in a monaural signal which is fed to the amplifier. Moreover, because the input ends of the input resistors have low input impedances, the input impedance viewed from the left and right channel input terminals are each given by the composite resistance of the one of the input resistor and the third, grounding, resistor. Providing the resistance values of the input resistors are equal to each other, the input impedances are also equal to each other, and an RC active filter comprising the amplifier and the RC circuit constitutes a band-pass filter having the same characteristic. Therefore, the left and the right channel audio signals can be mixed with each other and the band limiting operation for the mixed monaural audio signal can be obtained by a circuit simple in construction with almost the same complexity as conventional band-pass filters.

In the advantageous arrangement of the audio signal processing circuit according to the present invention, the first adder adds the low frequency component output from the audio signal processing circuit to the left channel audio input signal. The second adder adds the same low frequency component output from the audio signal processing circuit to the right channel audio input signal. Thus, the band intensified left and right channel audio signals are obtained from the first and the second adders, respectively. As the audio signal processing circuit having a simple construction has almost the same complexity as the conventional band-pass filters, it is possible to make the circuit smaller and cheaper.

For a better understanding of the present invention and to show how it may be brought into effect, reference will now be made, by way of example, to the accompanying drawings, in which:
Figure 1 is a circuit diagram showing a previously known audio signal processing circuit;
Figure 2 is a graph showing the frequency characteristic of the circuit shown in Figure 1;
Figure 3 is a circuit diagram showing the audio signal mixing circuit shown in Figure 1 in detail;
Figure 4 is a circuit diagram showing a preferred embodiment of the audio signal processing circuit according to the present invention; and
Figure 5 is a circuit diagram showing the audio signal processing circuit of Figure 4 in detail.

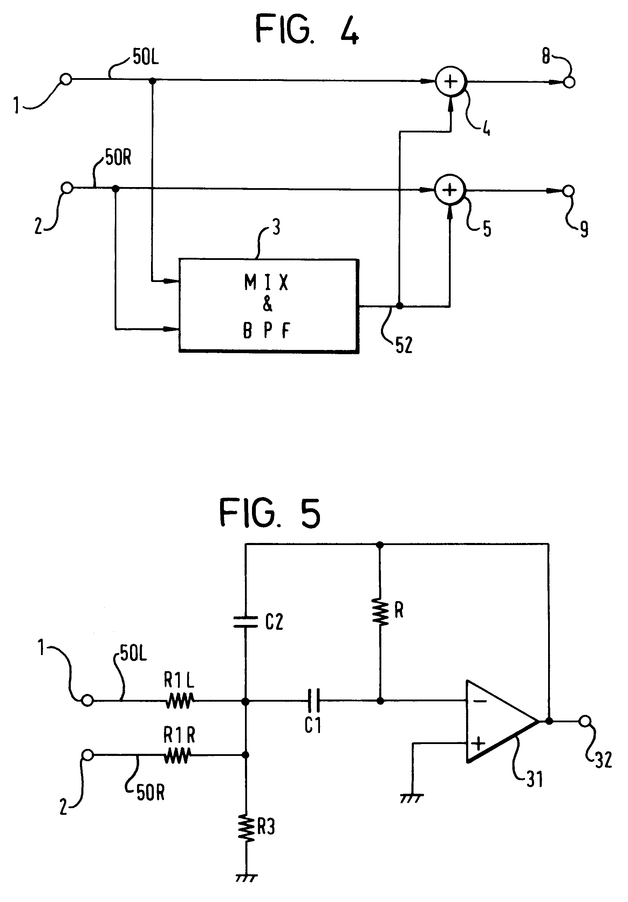

The present invention will now be described with reference to Figures 4 and 5.

Throughout the drawings, reference numerals or letters in Figure 1 through 3 will be used to designate like or equivalent elements for simplicity of explanation.

Referring now to Figure 4, an embodiment of the audio signal processing circuit according to the present invention will be described in detail.

Figure 4 shows an embodiment of the audio signal processing circuit for intensifying a prescribed low frequency band audio signal according to the present invention. Reference numeral 1 denotes an input terminal to which the left channel audio signal 50L is input. Reference numeral 2 denotes another input terminal to which the right channel audio signal 50R is input. Reference numeral 3 denotes an audio signal mixing and frequency range limiting circuit for mixing the left and the right channel audio signals 50L and 50R with each other so as to result a monaural audio signal, and for extracting only the low frequency component of this monaural audio signal to output therefrom. Reference numeral 4 denotes an adder for adding the low frequency component 52 to the left channel audio signal 50L. Reference numeral 5 denotes another adder for adding the low frequency component 52 to the right channel audio signal 50R. Reference numeral 8 denotes an output terminal for outputting the left channel audio signal with an intensified low frequency component formed by adder 4. Reference numeral 9 denotes a second output terminal for outputting the right channel audio signal with an intensified low frequency component formed by adder 5.

Now the operation of the first embodiment of the audio signal processing circuit according to the present invention will be explained. The left channel audio input signal 50L input at the left channel input terminal 1 is applied to the adder 4 and to the audio signal processing circuit 3. The right channel audio input signal 50R input at the right channel input terminal 2 is applied to the adder 5 and to the audio signal processing circuit 3. The audio signal processing circuit 3 mixes the left and the right channel audio signals 50L and 50R with each other so as to result in a monaural audio signal. The audio signal processing circuit 3 further extracts the low frequency component 52 of the monaural audio signal and then supplies the low frequency component 52 to the adders 4 and 5. The adder 4 adds the low frequency component 52 to the left channel audio input signal 50L, as described above and then supplies the left channel audio signal with an intensified low frequency component to the left channel output terminal 8. The adder 5 adds the low frequency component 52 to the right channel audio input signal 50R, also as described above, and then supplies the right channel audio signal with an intensified low frequency component to the right channel output terminal 9. The intensified left and right channel audio signals are output from the left and the right channel output terminals 8 and 9, respectively, so as to be subjected for amplification by power amplifiers (not shown) and drives of left and right channel loudspeakers (not shown).

Referring now to Figure 5, the audio signal mixing and frequency band limiting circuit 3 in Figure 4 will be explained in detail. In this circuit 3, the input impedance of the circuit on each of the left and the right channel input terminals 1 and 2 becomes equal to the composite resistance R2 of an input resistor R1L (or R1R) and a third, grounding, resistors R3. That is, the input impedance or the composite resistance R2 is given by an equation of:$\text{R2 = 1/(1/R1 + 1/R3)}$

In other words, the input impedance viewed from the input terminal 1 is given by the composite resistance of the parallel circuit of the input resistor R1L coupled to the input terminal 1 and the third, grounding, resistor R3, as the input terminal 2 is at a low impedance. Also, the input impedance viewed from the input terminal 2 is given by the composite resistance of the parallel circuit of the input resistor R1R coupled to the input terminal 2 and the third, grounding, resistor R3, as the input terminal 1 is also at a low impedance. Accordingly, the left and the right channel audio input signals 50L and 50R are mixed with each other so as to form a monaural signal and then applied to the inverting input terminal of an operational amplifier 31 via a coupling capacitor C1. This monaural signal is limited to a prescribed frequency band by the band-pass filtering function of the combination of the operational amplifier 31 and the RC circuit consisting of a filtering capacitor C2 and a filtering resistor R, and the resulting band-limited signal is led to the output terminal 32 from the output of the operational amplifier 31. Here the resistors and capacitors are related or defined as follows.$\text{R1L = R1R = R1}$$\text{R = 2 x R1}$$\text{C1 = C2 = C}$

Here, as the input impedance of the circuit 3 respectively viewed from the input terminals 1 and 2 is equally given by the composite resistance R2 as defined by the above equation (1), a centre frequency f₀ and a bandwidth B of the band-pass filter consisting of the operational amplifier 31, the filtering capacitor C2 and the filtering resistor R are expressed as follows:$\text{B = 1/(2πR1 x C)}$${\text{f}}_{\text{o}} \text{² = 1/(8π² R1 x C²) x [(1/R1 + 1/R2)]}$

Accordingly, when the lower band resonance frequency F₀ of each of the left and the right channel loudspeakers is almost equal to the center frequency f₀ of the band-pass filter, as expressed by the equation (3), an intensified low frequency audio signal component suitable to compensate for the attenuation of the low frequency component of the sound generated from each of the loudspeakers can be extracted according to the circuit shown in Figures 4 and 5.

According to the above embodiment of the present invention, the audio signal processing circuit 3 mixes the left and the right channel audio signals 50L and 50R as well as extracts the low frequency component 52 from the mixed monaural audio signal. In addition, as this circuit 3 has a circuit size almost the same as known band-pass filters which have been used, it is possible to remove the conventional audio signal mixing circuit 6, as shown in Figure 3, therefore making the circuit smaller and less expensive.

As described above, the present invention can provide an extremely preferable audio signal precessing circuit. That is, the audio signal processing circuit of the present invention is able to mix the left and right channel audio signals with each other so as to result in a monaural audio signal, and to extract a prescribed low frequency component from the monaural audio signal, the circuit being simple in construction and cheaper in cost than previously known circuits.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefore, it is intended that the present invention not be limited to the particular embodiment disclosed as the best mode contemplated for carrying out the present invention, but that the present invention includes all embodiments falling within the scope of the appended claims.

## Claims

1. An audio signal processing circuit, comprising:
an amplifier (31) having an input terminal and an output terminal (32) with an RC filter connected between the output terminal (32) and the input terminal;
a first input resistor (R1L) for supplying a first audio signal to the input terminal of the amplifier (31);
a second input resistor (R1R) for supplying a second audio signal to the input terminal of the amplifier (31); and
a third resistor (R3) connected between a connection node of the first and the second input resistors and a reference potential source.

2. An audio signal processing circuit as claimed in claim 1 comprising:
means (1) for supplying a left channel audio signal to the first input resistor (R1L);
means (2) for supplying a right channel audio signal to the second input resistor (R1R);
first combining means (4) for combining the output signal from the amplifier (31) with the left channel audio signal to form an output left channel audio signal; and
second combining means (5) for combining the output signal from the amplifier (31) with the right channel audio signal to form an output right channel audio signal.

3. An audio signal processing circuit as claimed in claim 2 wherein the amplifier (31) has a non-inverting input terminal and an inverting input terminal, the first and second input resistors (R1L, R1R) both being coupled to the inverting input terminal, and wherein the first and second combining means are adding means for adding the output signal from the amplifier means (31) to the left and right channel audio signals, respectively.

4. An audio signal processing circuit as claimed in claim 2 or 3 wherein the values of first and second input resistors (R1L, R1R) and third resistor (R3) are chosen such that the input impedance of the amplifier is low.

5. An audio signal processing circuit as claimed in claim 2, 3 or 4 for supplying left and right channel signals to first and second loudspeakers, wherein the values of the RC network are chosen such that the center frequency of the filter implemented by the RC network is made equal to the lower band resonance frequency of the channel loudspeakers.

6. An audio signal processing circuit as claimed in any previous claim wherein the third resistor (R3) is connected to ground.
